# EUROPEAN PATENT APPLICATION

(11) **EP 3 486 956 A1**
(43) Date of publication of application: **22.05.2019**
(21) Application number: 18185855.6
(22) Date of filing: 26.07.2018
(51) Int. Cl.: H01L 31/18, H01L 21/673

(54) **SOLAR CELL SILICON WAFER CARRYING DEVICE AND TRANSMISSION SYSTEM**

(30) Priority: 16.11.2017 CN 201721539658 U
(71) Applicant: Beijing Juntai Innovation Technology Co., Ltd, 100176 Beijing (CN)
(72) Inventor: YUAN, Shicheng, BEIJING, Beijing 100176 (CN); ZHANG, Fenggang, BEIJING, Beijing 100176 (CN); YANG, Xixi, BEIJING, Beijing 100176 (CN)
(74) Representative: Allain, Laurent

(57) **Abstract**

A solar cell silicon wafer carrying device and a transmission system are provided, wherein the solar cell silicon wafer carrying device comprises a tray (10) and an auxiliary mask member (20), and a side surface of the tray (10) is provided with a spacing slot (11) and a receiving slot (12). The spacing slot (11) and the receiving slot (12) are arranged in a stepped manner with the spacing slot (11) located below the receiving slot (12). The auxiliary mask member (20) covers over the receiving slot (12) and is provided with a mask hole (21) in communication with the receiving slot (12). The mask hole (21) is provided along a perimeter thereof with a shielding portion (213) for shielding an edge of the receiving slot (12).

## Description

### CROSS-REFERENCE TO RELATED APPLICATION

This application claims priority to Chinese Application No. 201721539658.5 filed with the Chinese Intellectual Property Office on November 16, 2017, the disclosure of which is incorporated herein in its entirety by reference.

### TECHNICAL FIELD

The present disclosure relates to a technical field of workpiece loading, and particularly relates to a solar cell silicon wafer carrying device and a transmission system.

### BACKGROUND

Solar cell is a kind of photoelectric conversion device developed based on photovoltaic effect. At present, solar cells in the international photovoltaic market mainly include the types of crystalline silicon (including single crystal silicon and polycrystalline silicon), amorphous/single crystal heterojunction (HIT), amorphous silicon film, cadmium telluride (CdTe) film, copper indium selenide (CIS) film and so on.

In the manufacturing process of solar cells such as crystalline silicon solar cells and HIT solar cells, silicon wafer is the main raw material, and the core process is to deposit one or more solid films on a surface of the silicon wafer by a process such as PVD and PECVD. Since silicon wafer is small in size (an exemplified typical size thereof is about 156 mm × 156 mm × 0.18 mm) and is fragile, it is necessary to ensure a stable transmission and reliable location of the silicon wafer during processing of the solar cell.

Currently, silicon wafers are directly transmitted by a conveyor belt, which may easily cause the silicon wafer to be broken, thereby leading to irreparable loss.

In addition, a coating process of a solar cell generally involves depositing a plurality of layers on a silicon wafer or a substrate, during which a film layer is also deposited on a side surface of another film layer. In order to avoid electric leakage between subsequent film layers, it is necessary to insulate peripheral side surfaces of a cell piece after the coating is completed.

Currently, the side surfaces of a cell piece are usually insulated by grinding off film layers on the side surfaces of the cell piece with a grinding tool. However, the grinding process may easily cause breakage of the cell piece and decrease in production efficiency.

### SUMMARY

An object of the present disclosure is to provide a solar cell silicon wafer carrying device and a transmission system to at least partially solve the above problems, protect the solar cell silicon wafer during transmission thereof, prevent a side coating of the solar cell during a coating process, and thus prevent breakage of the solar cell silicon wafer.

According to an aspect of the disclosure, there is provided a solar cell silicon wafer carrying device, comprising: a tray, which is provided at a side surface thereof with a spacing slot and a receiving slot arranged in a stepped manner, the spacing slot being located below the receiving slot; an auxiliary mask member, which covers over the receiving slot and is provided with a mask hole in communication with the receiving slot, the mask hole being provided along a perimeter thereof with a shielding portion for shielding an edge of the receiving slot.

In an exemplary embodiment, the solar cell silicon wafer carrying device further includes a bottom plate for carrying the tray, the bottom plate being capable of carrying at least two of the trays.

In an exemplary embodiment, the tray is fixedly connected to an upper surface of the bottom plate.

In an exemplary embodiment, an identification code is provided on the bottom plate.

In an exemplary embodiment, the tray is connected to the bottom plate by a locating pin.

In an exemplary embodiment, the bottom plate and the tray are integrally formed.

In an exemplary embodiment, the receiving slot and the mask hole both have a square shape, and when the auxiliary mask member covers over the receiving slot, lateral and longitudinal central axes of the receiving slot respectively coincide with lateral and longitudinal central axes of the mask hole.

In an exemplary embodiment, the mask hole includes a vertical hole (straight hole) section and a flared hole section, and a cross-sectional area of an end of the flared hole section proximal to the vertical hole section is smaller than a cross-sectional area of an end of the flared hole section distal to the vertical hole section; a cross-sectional area of the vertical hole section is smaller than a cross-sectional area of the receiving slot; and when the auxiliary mask member covers over the receiving slot, the vertical hole section is matched with the receiving slot.

In an exemplary embodiment, a side length of the receiving slot is greater than a side length of the vertical hole section by a preset value.

In an exemplary embodiment, a support table is disposed in the spacing slot, and an upper end face of the support table is flush with a bottom of the receiving slot.

According to another aspect of the disclosure, there is provided a solar cell silicon wafer transmission system comprising any one of the above mentioned solar cell silicon wafer carrying devices.

### BRIEF DESCRIPTION OF FIGURES

Fig. 1 is a structural schematic view of a solar cell silicon wafer carrying device in an embodiment of the disclosure;
Fig. 2 is a sectional schematic view of a tray of a solar cell silicon wafer carrying device in an embodiment of the disclosure;
Fig. 3 is a sectional schematic view of a tray of a solar cell silicon wafer carrying device and a solar cell silicon wafer carried on the tray in an embodiment of the disclosure;
Fig. 4 is a sectional schematic view of an auxiliary mask member of a solar cell silicon wafer carrying device in an embodiment of the disclosure; and
Fig. 5 is a sectional schematic view of a solar cell silicon wafer carrying device in an embodiment of the disclosure in use.

### DETAILED DESCRIPTION

Embodiments of the disclosure will now be described in detail. Examples of the embodiments are shown in the drawings throughout which, the same or similar reference signs refer to the same or similar elements or elements with the same or similar functions. The embodiments described below with reference to the drawings are merely illustrative, and are used only for the purpose of explaining the disclosure and should not be interpreted as limitations to the disclosure. It is noted that, as used in this specification and the appended claims, the term "a" or "an" includes plural referents unless expressly and unequivocally limited to one referent.

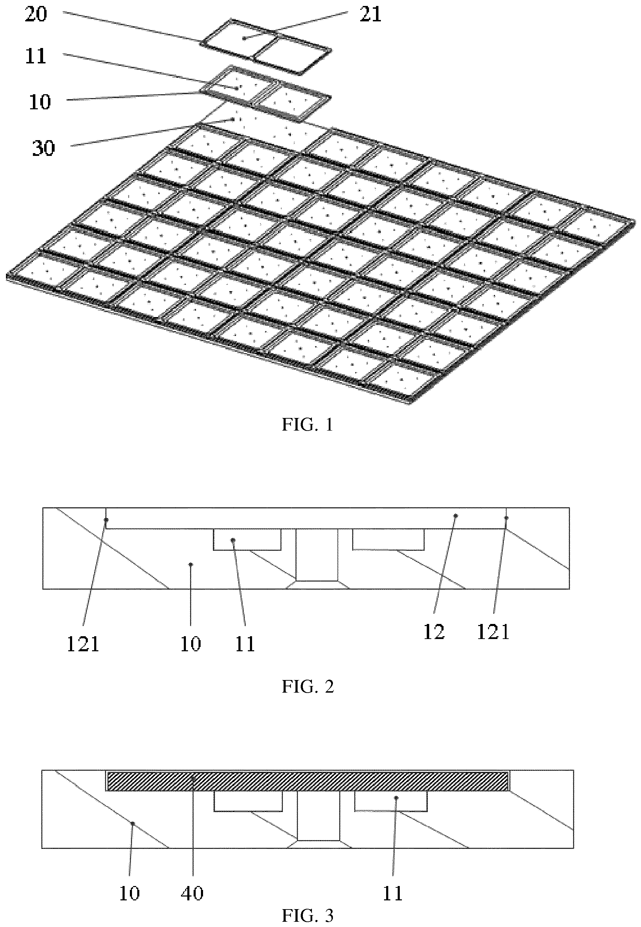

As shown in Figs. 1-5, a solar cell silicon wafer carrying device provided in an embodiment of the disclosure includes a tray 10 and an auxiliary mask member 20. In Fig. 1, two trays 10 and two auxiliary mask members 20 are in a separated state, while the remaining trays 10 and the remaining auxiliary mask members 20 are in a fitted state.

Referring to Figs. 2 and 3, a side surface of the tray 10 is provided with a spacing slot 11 and a receiving slot 12. The spacing slot 11 and the receiving slot 12 are arranged in a stepped manner, and the spacing slot 11 is located below the receiving slot 12. Preferably, a cross-sectional area of the receiving slot 12 is greater than a cross-sectional area of the spacing slot 11 so that a step capable of supporting the solar cell silicon wafer 40 is formed between the receiving slot 12 and the spacing slot 11. The receiving slot 12 is used for receiving (accommodating) the solar cell silicon wafer 40. As shown in Fig. 3, the solar cell silicon wafer 40 is placed on the step which is between the receiving slot 12 and the spacing slot 11. The spacing slot 11 allows the solar cell silicon wafer 40 to be in an overhead state (suspended state) when the solar cell silicon wafer 40 is placed in the receiving slot 12, so as to facilitate a manipulator to pick up the solar cell silicon wafer 40. Preferably, a volume of the receiving slot 12 is adapted to a volume of the solar cell silicon wafer 40 to be received therein. Preferably, an edge of the solar cell silicon wafer 40 is in clearance fit with a sidewall of the receiving slot 12. Preferably, the receiving slot 12 is provided with a limiting portion 121, which is a sidewall of the receiving slot 12.

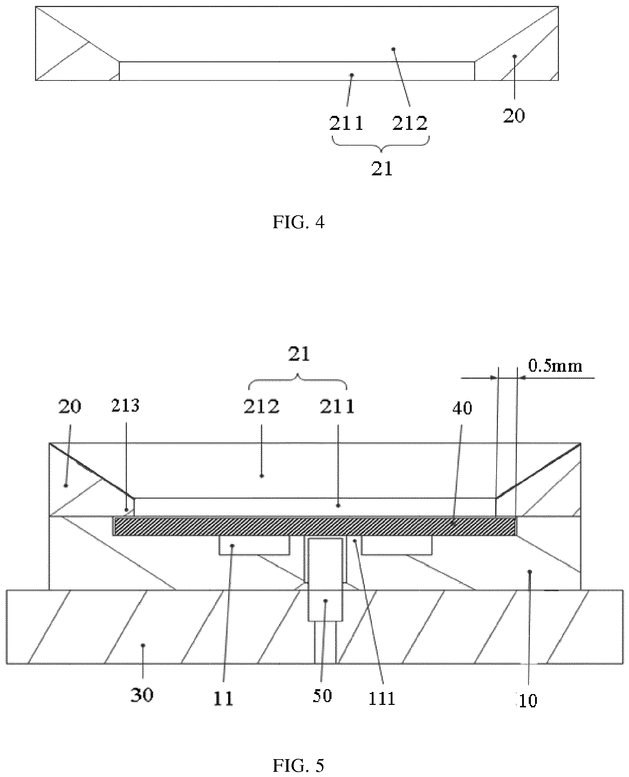

Preferably, to avoid damage to the solar cell silicon wafer 40, a depth of the receiving slot 12 is slightly greater than a thickness of the solar cell silicon wafer 40. In addition, preferably, as shown in Fig. 5, in order to better support the solar cell silicon wafer 40 and to prevent a central portion of the solar cell silicon wafer 40 from being deformed due to lack of support, a support table 111 is disposed in the spacing slot 11 with an upper end face of the support table 111 being flush with a bottom of the receiving slot 12. When the solar cell silicon wafer 40 is placed in the receiving slot 12, the central portion of the solar cell silicon wafer 40 is supported on the support table 111 and thus the solar cell silicon wafer 40 is protected from being deformed. Preferably, the number of support table may be set according to a size of the solar cell silicon wafer. Further, the support table 111 may be integrally formed with the tray 10.

Referring to Fig.4, the auxiliary mask member 20 covers over the receiving slot 12 and is provided with a mask hole 21 in communication with the receiving slot 12. Along a perimeter of the mask hole 21, the mask hole 21 is provided with a shielding portion 213 for shielding an edge of the receiving slot 12. Referring to Fig. 5, the mask hole 21 is a through hole formed in the auxiliary mask member 20, and the shielding portion 213 may shield a part of the receiving slot 12. Therefore, when the solar cell silicon wafer 40 is loaded in the receiving slot 12 and the auxiliary mask member 20 covers over the tray 10, an edge of the solar cell silicon wafer 40 is shielded by the shielding portion 213 of the auxiliary mask member 20. Preferably, as shown in Fig. 5, the edge of the solar cell silicon wafer 40 is shielded by 0.5±0.01 mm. In an example of the embodiment, the shielding portion 213 is formed by a part of the auxiliary mask member 20 enclosing the mask hole 21.

Generally, the solar cell silicon wafer 40 has a square shape. Accordingly, the receiving slot 12 and the mask hole 21 also have a square shape. Since the shielding portion 213 is required to shield an edge of the receiving slot 12, and a vertical hole section 211 (which will be described in detail later) is matched with the receiving slot 12 when the auxiliary mask member 20 covers over the receiving slot 12, a side length of the vertical hole section 211 is required to be smaller than a side length of the receiving slot 12. As described above, the edge of the solar cell silicon wafer 40 is shielded by about 0.5 mm, and the volume of the receiving slot 12 is adapted to the volume of the solar cell silicon wafer 40. Therefore, the side length of the receiving slot 12 is required to be greater than that of the vertical hole section 211 by a preset value of 1 mm. It should be understood that, when the auxiliary mask member 20 covers over the receiving slot 12, lateral and longitudinal central axes of the receiving slot 12 respectively coincide with lateral and longitudinal central axes of the mask hole 21. In this manner, it is ensured that each of the edges of the solar cell silicon wafer 40 is shielded by 0.5 mm. Strictly speaking, it should be said that a side length of the vertical hole section 211 is smaller than the side length of the solar cell silicon wafer 40 by 1 mm. However, since the volume of the receiving slot 12 is adapted to the volume of the solar cell silicon wafer 40, the above descriptions all adopt the expression that the side length of the receiving slot 12 is required to be greater than the side length of the vertical hole section 211 by a preset value of 1 mm. Apparently, if the solar cell silicon wafer 40 has a circle shape, a diamond shape or other shapes, the shape of the receiving slot 12 is also required to be adjusted accordingly.

Preferably, the mask hole 21 includes the vertical hole section 211 and a flared hole section 212. A cross-sectional area of an end of the flared hole section 212 proximal to the vertical hole section 211 is smaller than a cross-sectional area of an end of the flared hole section 212 distal to the vertical hole section 211. A cross-sectional area of the vertical hole section 211 is smaller than a cross-sectional area of the receiving slot 12. When the auxiliary mask member 20 covers over the receiving slot 12, the vertical hole section 211 is matched with the receiving slot 12. That is, the vertical hole section 211 is in direct communication with the receiving slot 12. Since the cross-sectional area of the vertical hole section 211 is smaller than the cross-sectional area of the receiving slot 12 while the volume of the receiving slot 12 is adapted to the volume of the solar cell silicon wafer 40, edges of the solar cell silicon wafer 40 are shielded.

During masking of the solar cell silicon wafer 40, the shielded portion of the solar cell silicon wafer 40 is not masked, while the remaining portion thereof is masked through the mask hole 21. With such structure, a structural strength of the auxiliary mask member 20 is guaranteed, the edges and the sides (peripheral sides) of the solar cell silicon wafer are prevented from being coated, thereby avoiding subsequent insulation treatment to the sides of the solar cell silicon wafer, and thus reducing occurrence of breakage of the solar cell silicon wafer and improving yield and production efficiency of the solar cell silicon wafer.

With the solar cell silicon wafer carrying device provided in the embodiment of the disclosure, the solar cell silicon wafer 40 is loaded in the solar cell silicon wafer carrying device during transmission so that the solar cell silicon wafer 40 is protected during transmission and occurrence of breakage of solar cell silicon wafer 40 is avoided. Before being masked, the solar cell silicon wafer 40 is loaded in the receiving slot 12 of the tray 10, and then the tray 10 is covered by the auxiliary mask member 20. The mask hole 21 provided on the auxiliary mask member 20 may assist in masking the solar cell silicon wafer 40. During masking of the solar cell silicon wafer 40, a part of the receiving slot 12 is shielded by the shielding portion 213, thereby preventing the edges and the sides the solar cell silicon wafer 40 from being coated, avoiding subsequent insulation treatment to the sides of the solar cell silicon wafer 40, and thus reducing occurrence of breakage of the solar cell silicon wafer 40 and improving yield and production efficiency of the solar cell silicon wafer 40.

Further, in order to improve transmission efficiency, the solar cell silicon wafer carrying device may further include a bottom plate 30 for carrying the tray 10. The bottom plate 30 is capable of carrying at least two trays 10. Since the bottom plate 30 is capable of carrying a plurality of trays 10, synchronous transmission of a plurality of solar cell silicon wafers 40 is realized while problems such as mutual collisions are avoid. As shown in Fig. 1, a plurality of (fifty six) trays 10 are placed on the bottom plate 30.

During transmission, in order to identify different bottom plates 30, a unique identification code may be provided on each of the bottom plates 30 to realize scheduling and identification on a transmission line.

Preferably, in order to improve stability, the tray 10 is fixedly connected to an upper surface of the bottom plate 30. The tray 10 may be fixed onto the bottom plate 30 by a fastener such as a bolt or screw.

The tray 10 may also be connected to the bottom plate 30 by a locating pin 50. For example, the locating pin 50 may be provided on the bottom plate 30, while a locating hole matched with the locating pin 50 is provided on the tray 10. In use, the locating pin 50 is firstly inserted into the locating hole to achieve positioning, and then a fixing step is performed through a fastener, thus the assembly efficiency of the tray 10 is improved. In an embodiment, the tray 10 and the bottom plate 30 may be integrally formed.

The present disclosure further provides a solar cell silicon wafer transmission system comprising the solar cell silicon wafer carrying device provided in any embodiment of the disclosure. When solar cell silicon wafers 40 need to be transported, the solar cell silicon wafer carrying device is placed on a device such as a conveyor belt, and then the solar cell silicon wafers 40 are placed in the solar cell silicon wafer carrying device, facilitating the transmission of the solar cell silicon wafers 40.

The structures, features, and effects of the present disclosure have been described in detail with reference to the embodiments shown in the drawings. The above embodiments are merely preferred embodiments of the present disclosure, and the scope of the disclosure is not limited as shown in the drawings. Any change made based on the idea of the present disclosure, or equivalent embodiments that are modified to equivalent variations, should still fall within the protection scope of the disclosure if they do not go beyond the spirit covered by the description and the drawings.

### Reference Signs:

10 - tray
11 - spacing slot
111 - support table
12 - receiving slot
121 - limiting portion
20 - auxiliary mask member
21 - mask hole
211 - vertical hole section
212 - flared hole section
213 - shielding portion
30 - bottom plate
40 - solar cell silicon wafer
50 - locating pin

## Claims

1. A solar cell silicon wafer carrying device, comprising:
a tray (10), which is provided at a side surface thereof with a spacing slot (11) and a receiving slot (12) arranged in a stepped manner, the spacing slot (11) being located below the receiving slot (12); and
an auxiliary mask member (20), which covers over the receiving slot (12) and is provided with a mask hole (21) in communication with the receiving slot (12), the mask hole (21) being provided along a perimeter thereof with a shielding portion (213) for shielding an edge of the receiving slot (12).

2. The solar cell silicon wafer carrying device according to claim 1, further comprising a bottom plate (30) for carrying the tray (10), the bottom plate (30) being capable of carrying at least two of the trays (10).

3. The solar cell silicon wafer carrying device according to claim 2, wherein the tray (10) is fixedly connected to an upper surface of the bottom plate (30).

4. The solar cell silicon wafer carrying device according to claim 2, wherein an identification code is provided on the bottom plate (30).

5. The solar cell silicon wafer carrying device according to claim 2, wherein the tray (10) is connected to the bottom plate (30) by a locating pin (50).

6. The solar cell silicon wafer carrying device according to claim 2, wherein the bottom plate (30) and the tray (10) are integrally formed.

7. The solar cell silicon wafer carrying device according to any one of claims 1-6, wherein the receiving slot (12) and the mask hole (21) both have a square shape, and
when the auxiliary mask member (20) covers over the receiving slot (12), lateral and longitudinal central axes of the receiving slot (12) respectively coincide with lateral and longitudinal central axes of the mask hole (21).

8. The solar cell silicon wafer carrying device according to claim 7, wherein the mask hole includes a vertical hole section (211) and a flared hole section (212), and a cross-sectional area of an end of the flared hole section (212) proximal to the vertical hole section (211) is smaller than a cross-sectional area of an end of the flared hole section (212) distal to the vertical hole section (211);
a cross-sectional area of the vertical hole section (211) is smaller than a cross-sectional area of the receiving slot (12); and
when the auxiliary mask member (20) covers over the receiving slot (12), the vertical hole section (211) is matched with the receiving slot (12).

9. The solar cell silicon wafer carrying device according to claim 8, wherein a side length of the receiving slot (12) is greater than a side length of the vertical hole section (211) by a preset value.

10. The solar cell silicon wafer carrying device according to any one of claims 1-6, wherein a support table (111) is disposed in the spacing slot (11), and an upper end face of the support table (111) is flush with a bottom of the receiving slot (12).

11. A solar cell silicon wafer transmission system comprising the solar cell silicon wafer carrying device according to any one of claims 1-10.
